# EUROPÄISCHE PATENTANMELDUNG

(11) **EP 0 619 518 A1**
(43) Veröffentlichungstag der Anmeldung: **12.10.1994**
(21) Anmeldenummer: 94104940.5
(22) Anmeldetag: 29.03.1994
(51) Int. Cl.: G03F 1/14, G03F 7/00, G03F 7/11

(54) **Trägermaterial und Verfahren zur Vorbehandlung solcher Trägermaterialien**

(30) Priorität: 03.04.1993 DE 4310976
(71) Anmelder: INSTITUT FÜR MIKROTECHNIK MAINZ GmbH, D-55129 Mainz-Hechtsheim (DE)
(72) Erfinder: Ehrfeld, Wolfgang, Prof. Dr., D-55116 Mainz (DE); Abraham, Michael, Dr., D-55129 Mainz (DE); Schenk, Rainer, Dr., D-65451 Kelsterbach (DE); Löwe, Holger, Dr., D-55276 Oppenheim (DE); Schmidt, Martin, Dr., D-14193 Berlin (DE)
(74) Vertreter: Fuchs, Luderschmidt & Partner Patentanwälte

(57) **Zusammenfassung**

Es wird Trägermaterial zur Verwendung in der Röntgentiefenlithographie beschrieben. Als Substrat für Röntgenresistmaterial und Absorberschichten eignet sich Glaskohlenstoffmaterial, das zur Verbesserung der Haftung mit einem Plasma, vorzugsweise Sauerstoffplasma, vorbehandelt wird.

## Beschreibung

Die Erfindung betrifft ein Trägermaterial für Röntgenresistmaterial und Masken zur Verwendung in der Röntgentiefenlithographie. Die Erfindung bezieht sich auch auf ein Verfahren zur Vorbehandlung solcher Trägermaterialien.

Die Tiefenlithographie, und hier insbesondere die LIGA-Technik (Lithographie, Galvanoformung, Abformung) ist eine mikrotechnische Basistechnologie, die es ermöglicht, dreidimensionale Mikrostrukturen beliebiger Querschnittsgeometrie aus Kunststoffen, Metallen und Keramiken zu fertigen (W. Ehrfeld, D. Münchmeyer: Three-dimensional microfabrication using synchrotron radiation, Nuclear instruments and Methods in Physical Research A303 (1991) S. 523 - 531). Die Höhen der Bauteile erreichen Werte bis zu 1 mm bei kleinsten lateralen Abmessungen im Mikrometerbereich und einer Strukturgenauigkeit im Submikrometerbereich über die gesamte Strukturhöhe. Im ersten Schritt des LIGA-Verfahrens, der Röntgentiefenlithographie, werden die durch den Absorber vorgegebenen Strukturen auf eine Röntgenmaske durch Schattenprojektion mit Synchrotronstrahlung in eine mehrere hundert Mikrometer dicke Resistschicht übertragen. Dabei wird häufig Polymethylmethacrylat als Resist verwendet. Die bestrahlten Bereiche des Resists können mit einem geeigneten Entwickler selektiv gegen die durch den Absorber abgedeckten Bereiche herausgelöst werden. Dadurch entsteht eine primäre Mikrostruktur, die z.B. Ausgangspunkt für die Herstellung eines metallischen Formeinsatzes ist. Das geschieht durch Auffüllung der Hohlräume, beispielsweise mittels galvanischer Abformung. Mit dem Formeinsatz können in einem Massenfertigungsverfahren die gewünschten Mikrobauteile über Reaktions- oder Spritzguß gefertigt werden.

Der Erfolg der LIGA-Technik hängt von der Beherrschung einer Vielzahl von technologischen Einzelschritten ab. Ein wichtiges Problem ist die Auswahl eines optimalen Trägermaterials, auf dem der Resist aufgebracht wird. Das Substrat muß folgende Anforderungen erfüllen:
- hohe Formstabilität, um die Formtreue der Mikrobauteile zu gewährleisten
- gute Resist-Substrathaftung
- ausreichende Leitfähigkeit und Startpunktdichte für den Galvanikprozeß
- geringe Rückstreuung von Sekundärelektronen an der Grenzfläche Substrat/Resist.

Außerdem ist es günstig, wenn das Substrat einen thermischen Ausdehnungskoeffizienten besitzt, der dem des verwendeten Resists möglichst nahe kommt. Vorteilhaft ist auch eine gute Wärmeleitfähigkeit, um die bei der Bestrahlung erzeugte Wärme rasch abführen zu können.

Die zur Zeit gängigsten Substrate in der LIGA-Technik sind Metallplatten (Kupfer, Titan). Diese Materialien erfüllen die Anforderungen hinsichtlich der mechanischen und thermischen Eigenschaften. Zur Gewährleistung der Haftung gegenüber PMMA wird beispielsweise im Fall von Kupfer oder Edelstahl als Substrat eine Titanschicht aufgebracht, die zusätzlich mechanisch aufgerauht und/oder oxidiert wird.

Eine weitere Verbesserung der Resist-Haftung erbrachte eine chemische Anbindung. Zu diesem Zweck setzte man dem aus dem Resist-Material bestehenden Gießharz eine interne Haftvermittlersubstanz zu. Eine bevorzugte funktionelle Gruppe der Haftvermittlersubtanz ist die Trimethoxysilyl-Gruppe. Ihre Wirkung setzt die Hydrolysierung der Oxidschicht der Substratoberfläche voraus (J. Mohr, W. Ehrfeld, D. Münchmeyer, KFK-Bericht 4414, Juli 1988).

Andere Methoden zur Verbesserung der Resist-Substrat-Haftung beruhen auf dem Einsatz von externen Haftvermittlersubstanzen, die als monomolekulare Lage auf das Substrat aufgebracht werden. Sie gewährleisten eine kovalente Kopplung zwischen dem Substrat und dem Resist (DE 42 34 423.9). Die galvanische Auffüllung der nach der Belichtung und Entwicklung entstandenen Gräben im Resist bereitet keine Probleme.

Trotz zufriedenstellender Ergebnisse dieser Technologie für Resistschichtdicken bis zu 500 µm kommt es insbesondere bei größeren Resistschichtdicken und/oder sehr kleinen Strukturen zu Ablöseerscheinungen des Resists an der Grenze zum Substrat, die sich besonders im Randbereich der Mikrostruktuen bemerkbar machen. Das kann zur kompletten Ablösung der Mikrostrukturen führen.

Weiterhin kommt es im Verlauf des Galvanikprozesses zu einer unerwünschten Unterplatierung in den bevorzugt abgelösten Randbereichen. Dieses Phänomen wird nicht auf ein Versagen des Haftvermittlers zurückgeführt, sondern hängt vielmehr mit der Erzeugung von Photo- und Sekundärelektronen an der Resist-Substrat-Grenzfläche zusammen, welche den Resist direkt oberhalb des Substrates zerstören. Diese Photo- und Sekundärelektronen entstehen vor allem durch inelastische Streuung der harten Anteile der Synchrotronstrahlung an der Resist-Substrat Grenzfläche.

Der mit der mittleren Ordnungszahl ansteigende Wirkungsquerschnitt und das Auftreten von Absorptionskanten dieses Streuprozesses erfordert ein bezüglich der Entstehung von Sekundärelektronen angepaßtes Resist-Substratsystem. Das ist umso wichtiger, je höher die Quantenenergie der verwendeten Synchrotronstrahlung ist. Bei größer werdenden Resistdicken ist man jedoch gezwungen, zu härteren Bereichen der Synchrotronstrahlung überzugehen. Das hängt mit der Absorption der Röntgenstrahlung im Resist zusammen, die mit abnehmender Wellenlänge abnimmt. Nur durch Verwendung härterer Röntgenstrahlung gelingt es, auch die tieferen Bereiche des Resists mit einer ausreichenden Dosis zu belichten, ohne die darüber liegenden Bereiche so stark zu bestrahlen, daß ein unerwünschtes Aufschäumen des Materials eintritt.

Nachteilig ist auch, daß sich mit steigenden Quantenenergien der Kontrast der Röntgenmaske verschlechtert. Es treten immer mehr harte Röntgenphotonen durch die Absorberschicht hindurch und rufen unerwünscht aber zwangsweise die Beschädigung der Resists an der Grenzfläche zum Substrat durch Erzeugung von Photo- und Sekundärelektronen hervor. Dem kann nur teilweise durch Erhöhung der Goldabsorberschicht begegnet werden, da auch Photoelektronen aus den bestahlten Bereichen in die unbestrahlten Bereiche gestreut werden, und so die Ränder der Mikrostrukturen besonders stark schädigen. Nach der Entwicklung des Resists entstehen somit auch bei sehr hohem Kontrast die beobachteten kerbförmigen Spalte am Fuß der Mikrostrukturen. Laterale Kräfte werden deshalb besonders die schlanken Mikrostrukturen vom Substrat leicht lösen können.

Aus der DE 42 00 996 C1 ist ein Verfahren von nichtlinearen optischen Mikrobauelementen bekannt, bei dem ein Dreischichtresistmaterial verwendet wird, das sich auf einem Substrat befindet. Über das Material des Substrates werden jedoch keine Aussagen gemacht.

Neben den Trägermaterialien für den Röntgenresist werden in der Röntgentiefenlithographie Trägermaterialien für die Herstellung von Röntgenmasken benötigt, für die die gleichen Anforderungen wie für die eingangs beschriebenen Substrate gelten. Zusätzlich muß das Trägermaterial eine möglichst niedrige Ordnungszahl haben, um einen ausreichenden Kontrast gegenüber dem Absorbermaterial (z.B. Gold) zu gewährleisten.

Gleichzeitig muß die Membran eine ausreichende Leitfähigkeit aufweisen, um die Absorberschicht in einem Galvanikprozeß abscheiden zu können. Für die Realisierung eines hohen Kontrastes, wie er für die Belichtung großer Resistschichtdicken erforderlich ist, wird auch eine hohe mechanische Stabilität verlangt.

Gegenwärtig werden Titan-, Silizium-, Beryllium- und Diamantmembranen verwendet. Typische Goldabsorberschichten auf den Maskenmembranen betragen 10 bis 15 µm, wobei eine deutliche Erhöhung der Schichtdicke technologische Grenzen hat. Sie beeinträchtigt auch die Formtreue bei der Übertragung der Strukturen, da dicke Absorberstrukturen aufgrund ihrer inneren Spannungen zu einem lateralen Verzug der dünnen Maskenmembranen führen.

Diamantmembranen haben die besten mechanischen Eigenschaften und sind außerdem transparent, was die Justierung der Membran gegenüber dem Substrat erleichtert. Allerdings müssen dazu die entsprechenden Bereiche frei von undurchsichtigen Galvanikstartschichten sein. Nachteilig ist, daß für die Herstellung der Absorberschicht eine Galvanikstartschicht aufgebracht werden muß und Diamantmembranen zur Zeit nicht in gewünschter Qualität verfügbar sind.

Die DE 36 23 637 C2 beschreibt ein Verfahren zur Herstellung von Mikrostrukturen unterschiedlicher Strukturhöhe mittels der Röntgentiefenlithographie, bei dem die zuvor erwähnten Röntgenmasken verwendet werden. Diese kann aus einer transparenten Trägerfolie aus Beryllium bestehen, die Absorberstrukturen aus Gold, Aluminium und Siliziumdioxid trägt.

Die DE 33 08 373 A1 betrifft im Siebdruck verarbeitbare, katalytisch härtbare Reaktionsmassen zur Verklebung von Glaskohlenstoffelektroden zu Doppelschichtkondensatoren. Die Glaskohlenstoffelektroden werden mit einer dünnen Reaktionsschicht an den für die Verklebung vorgesehenen Flächen versiegelt und anschließend wird auf eine Seite der Elektrode ein Rahmen aus Reaktionsharzmasse gedrückt und angehärtet.

Aufgabe der Erfindung ist es daher, ein Trägermaterial zu finden, das eine hohe Formstabilität, gute Resist-Substrat-Haftung, gute Leitfähigkeit, möglichst geringe Rückstreuung der Photo- und Sekundärelektronen an der Grenzschicht Substrat/Resist und eine möglichst geringe Ordnungszahl aufweist.

Es hat sich überraschend herausgestellt, daß alle diese Anforderungen von Glaskohlenstoff erfüllt werden, so daß dieses Material für den Einsatz in der Röntgentiefenlithographie als Trägermaterial sowohl für Röntgenresistmaterial als auch für Masken hervorragend geeignet ist.

Glaskohlenstoff besteht zu 99% aus Kohlenstoff und wird durch Pyrolyse aus Kunstharzen hergestellt. Glaskohlenstoff ist an sich bekannt und wird beispielsweise in R. Dübgen, H. Schlachter: Glasartiger Kohlenstoff Sigradur - ein Werkstoff für Chemie und Technik, Z. Werkstofftechnik 15 (1984) S. 331 - 338 beschrieben.

Als Einsatzgebiete für dieses bekannte Material werden die Herstellung von Laborgeräten Schmelzgefäßen für hochreine Verbindungen, Motorenteile sowie Anwendungen in der Medizintechnik genannt.

Der Einsatz als Trägermaterial für Resistmaterial und Masken in der Mikrotechnik ist bisher unbekannt.

Vermutlich scheiterte ein diesbezüglicher Einsatz von Glaskohlenstoff daran, daß das bekannte Material aufgrund seiner graphitischen Struktur schlechte Haftungseigenschaften aufweist. Glaskohlenstoff besitzt nämlich keine einfach hydrolysierbare Oxidhaut.

Der Einsatz von Haftvermittler brachte zwar eine Verbesserung, die für bestimmte Einsatzbereiche ausreicht, für die Verwendung in der LIGA-Technik war die erzielte Haftung des Glaskohlenstoffs jedoch noch nicht zufriedenstellend.

Es hat sich überraschend herausgestellt, daß eine deutliche Haftungsverbesserung insbesondere in Bezug auf Resist- und Absorbermaterialien dann erreicht werden kann, wenn vor dem Aufbringen dieser Materialien eine Plasmabehandlung, vorzugsweise eine Sauerstoffplasmabehandlung durchgeführt wird.

Die Plasmabehandlung wird vorteilhafterweise in einer Plasmaanlage bei einem Partialdruck von 0,1 - 10 Pa für eine Dauer von 1 bis 30 min durchgeführt.

Möglicherweise werden die im Glaskohlenstoff abgesättigten Bindungen durch die Plasmabehandlung aufgebrochen und durch die hierbei stattfindende oxidierende Behandlung nicht wieder vollständig abgesättigt, so daß ein metastabiler Zustand erreicht wird, der die Oberfläche für kurze Zeit nach der Plasmabehandlung reaktiv erhält. Dies erfordert jedoch, daß das Resist- oder das Absorbermaterial bzw. ein geeigneter Haftvermittler möglichst schnell nach der Plasmabehandlung aufgebracht wird.

### Beispiel:

Ein Glaskohlenstoffsubstrat wurde in einer Plasmaanlage bei 1.03 Pa Partialdruck Sauerstoff für eine Dauer von 15 min behandelt. Innerhalb von 15 min nach Beendigung der Plasmabehandlung wurde das Glaskohlenstoffsubstrat mit einer Monolage aus Trimethoxysilylpropylamin beschichtet. Ein Gießharz, bestehend aus 70 Gew.-% Methylmethacrylat und 30 Gew.-% vorpolymerisiertem PMMA wurde mit 0,8% Benzoylperoxid intensiv durchmischt. Die so erhaltene Mischung wurde mittels des Gießverfahrens auf das Glaskohlenstoffsubstrat aufgebracht.

Die Haftvermittlung wurde im LIGA-Prozeß getestet. Dabei wurde eine 50 µm-dicke PMMA-Schicht mit Synchrotronstrahlung bestrahlt. Die Haftfestigkeit wurde anhand der Standfestigkeit von 20 x 20 µm² großen Säulen beurteilt.

Bei einer Resistdicke von 50 µm bleiben alle Säulen stehen. Ohne Vorbehandlung des Substrats mit Plasma und ohne Aufbringung des Haftvermittlers löst sich die PMMA-Schicht schon vor der Belichtung.

Glaskohlenstoff besitzt eine Ordnungszahl, die gegenüber den üblichen Absorbermaterialien wie Gold gering, und gegenüber den üblichen Resistmaterialien, wie PMMA, angepaßt ist. Damit wird der Sprung in der Ordnungszahl an der Grenzfläche Resist-Substrat gegenüber dem heute üblicherweise verwendeten Metallsubstraten auf ein Minimum reduziert und eine optimale Anpassung an die mittlere Ordnungszahl des Resists erreicht. Die an der Resistgrenzfläche abgelagerte Dosis der schädigenden Photo- und Sekundärelektronen bei der Röntgentiefenlithographie läßt sich somit drastisch verringern.

Im Sinne der Reduzierung der Ordnungszahl der LIGA-Substrate werden zwar rußgefüllte Polymere bzw. leitfähige Polymere diskutiert. Rußgefüllte Polymere haben jedoch zwei Nachteile. Zum einen ist die Startpunktdichte für die Galvanik deutlich geringer als auf metallischen Substraten. Weiterhin können Rußpartikel aus dem Material austreten und den Elektrolyten verunreinigen. Leitfähige Polymere weisen darüber hinaus eine vergleichsweise geringe mechanische Stabilität auf, durch die die Strukturtreue der Mikrobauteile beeinträchtigt wird.

Darüber hinaus weist Glaskohlenstoff aufgrund seiner graphitischen Struktur eine ausreichend hohe Leitfähigkeit auf (spezifischer elektrischer Widerstand ca. 40 Ohm x µm), um den Galvanikprozeß durchführen zu können. Gegenüber rußgefüllten und anderen leitfähigen Polymeren hat das Material den Vorteil einer besseren Langzeitstabilität und höherer Galvanik-Startpunktdichte.

Die mechanischen Eigenschaften des Glaskohlenstoffmaterials gewährleisten eine hohe Formstabilität und Festigkeit, um in der Röntgentiefenlithographie eingesetzt zu werden.

Glaskohlenstoff kann auch mechanisch bearbeitet werden und besitzt eine hohe chemische Resistenz. Deshalb können die Substrate durch geeignete Oberflächenprozesse (z.B. Läppen, Polieren, Säurebehandlung) mehrfach regeneriert werden.

Die gute mechanische Bearbeitung ermöglicht die Herstellung von dünnen Trägerschichten für Röntgenmasken. Durch Läppen kann die Dicke des Ausgangsmaterials bis auf 20 µm verringert werden.

Wenn derartige Glaskohlenstoff-Folien als Membrane für Röntgenmasken eingesetzt werden, so liegt der Vorteil u.a. darin, daß das Kohlenstoffmaterial eine geringe Ordnungszahl gegenüber den Absorbermaterialien aufweist und somit eine ausreichende Transparenz im Spektralbereich der verwendeten Röntgenstrahlung aufweist. Ein Vorteil gegenüber Diamantmembranen ist, daß der für das Aufbringen des Absorbers erforderliche Galvanikprozeß problemlos auf Glaskohlenstoff durchgeführt werden kann. Dagegen muß auf die Diamantmembran eine Galvanikstartschicht aufgebracht werden. Diese zwei zusätzlichen Prozeßschritte werden durch Verwendung von Glaskohlenstoff vermieden. Durch Polieren kann sogar optische Qualität des Glaskohlenstoffs erreicht werden. Diamentmembrane besitzen dagegen stets eine Restrauhigkeit, die durch die Kristallinität des Materials bedingt ist.

Ein weiterer Vorteil besteht im niedrigen Ausdehnungskoeffizienten der Glaskohlenstoffolien. Dadurch wird eine gute Dimensionsstabilität im Falle lokaler Erwärmungen bei Bestrahlung gewährleistet.

## Patentansprüche

1. Trägermaterial für Röntgenresistmaterial und Masken zur Verwendung in der Röntgentiefenlithographie,
dadurch gekennzeichnet,
daß es aus Glaskohlenstoff besteht.

2. Trägermaterial nach Anspruch 1, dadurch gekennzeichnet, daß es aus einem mit einem Plasma vorbehandelten Glaskohlenstoff besteht.

3. Trägermaterial nach Anspruch 1 oder 2 für Röntgenmasken, dadurch gekennzeichnet, daß es aus einer Glaskohlenstoff-Folie besteht.

4. Trägermaterial nach Anspruch 3, dadurch gekennzeichnet, daß die Glaskohlenstoff-Folie eine Dicke von 20 bis 300 µm aufweist.

5. Verfahren zur Behandlung von Trägermaterialien nach Anspruch 1,
dadurch gekennzeichnet,
daß das Glaskohlenstoffmaterial zur Aktivierung der Oberfläche einem Plasma ausgesetzt wird.

6. Verfahren nach Anspruch 5, dadurch gekennzeichnet, daß das Glaskohlenstoffmaterial einem Sauerstoffplasma ausgesetzt wird.

7. Verfahren nach Anspruch 6, dadurch gekennzeichnet, daß das Glaskohlenstoffmaterial einer Sauerstoffbehandlung bei einem Partialdruck von 0,1 - 10 Pa für eine Dauer von 1 - 30 min. in der einer Plasmaanlage ausgesetzt wird.

8. Verfahren nach einem der Ansprüche 5 bis 7, dadurch gekennzeichnet, daß unmittelbar nach der Plasmabehandlung ein Haftvermittler auf die Oberfläche des Glaskohlenstoffmaterials aufgetragen wird.

9. Verfahren nach einem der Ansprüche 5 bis 7, dadurch gekennzeichnet, daß unmittelbar nach der Sauerstoffbehandlung das einen internen Haftvermittler aufweisende Resistmaterial auf die Oberfläche des Glaskohlenstoffmaterials aufgetragen wird.
